(19) Europäisches Patentamt
European Patent Office
Office européen des brevets

(11) **EP 2 471 089 B1**

(12) **EUROPÄISCHE PATENTSCHRIFT**

(45) Veröffentlichungstag und Bekanntmachung des Hinweises auf die Patenterteilung:
**19.06.2019  Patentblatt 2019/25**

(21) Anmeldenummer: **10743151.2**

(22) Anmeldetag: **18.08.2010**

(51) Int Cl.:
*H01L 21/335* (2006.01)    *H01L 29/778* (2006.01)

(86) Internationale Anmeldenummer:
**PCT/EP2010/062008**

(87) Internationale Veröffentlichungsnummer:
**WO 2011/023607 (03.03.2011 Gazette 2011/09)**

(54) **VERFAHREN ZUR BESTIMMUNG DER STRUKTUR EINES TRANSISTORS**

METHOD FOR DETERMINING THE STRUCTURE OF A TRANSISTOR

PROCÉDÉ POUR DÉTERMINER LA STRUCTURE D'UN TRANSISTOR

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **26.08.2009   DE 102009028918**

(43) Veröffentlichungstag der Anmeldung:
**04.07.2012   Patentblatt 2012/27**

(73) Patentinhaber: **Fraunhofer-Gesellschaft zur Förderung der angewandten Forschung e.V.
80686 München (DE)**

(72) Erfinder:
• **KÖHLER, Klaus
  79108 Freiburg (DE)**
• **MÜLLER, Stefan
  79194 Gundelfingen (DE)**
• **WALTEREIT, Patrick
  79100 Freiburg (DE)**

(74) Vertreter: **Friese Goeden Patentanwälte PartGmbB
Widenmayerstraße 49
80538 München (DE)**

(56) Entgegenhaltungen:
**US-A1- 2007 018 199     US-B2- 7 224 004**

**Beschreibung**

Die Erfindung betrifft ein Verfahren zur Bestimmung der Struktur eines Transistors, welcher zumindest eine erste Schicht, eine zweite Schicht und eine vierte Schicht enthält, wobei die vierte Schicht auf zweiten Schicht und die zweite Schicht auf der ersten Schicht angeordnet ist, die erste Schicht GaN enthält, die zweite Schicht $Al_xGa_{1-x}N$ und die vierte Schicht ein Metall oder eine Legierung enthält.

Aus der US 7 224 004 B2 ist ein Transistor der eingangs genannten Art bekannt. Dieser Transistor weist zumindest eine erste und eine dritte Schicht auf, welche GaN enthalten. Dazwischen ist eine zweite Schicht angeordnet, welche AlGaN enthält. Aufgrund der unterschiedlichen Gitterkonstanten bilden sich mechanische Verspannungen innerhalb der Halbleiterstruktur, welche eine piezoelektrische Polarisation hervorrufen. Dadurch bildet sich an der Grenzfläche der ersten und der zweiten Schicht eine Bandverbiegung, an welcher sich ein zweidimensionales Elektronengas ausbildet. Auf diese Weise kann eine Zone erhöhter elektrischer Leitfähigkeit innerhalb des Transistors ausgebildet werden, ohne Dotierstoffe in das Material einbringen zu müssen. Durch Anlegen einer elektrischen Spannung an eine auf der dritten Schicht aufgebrachten vierten Schicht aus einem Metall, kann die Ladungsträgerdichte im Betrieb des Transistors beeinflusst werden.

Transistoren der eingangs genannten Art werden insbesondere als Leistungsverstärker für hochfrequente Signale eingesetzt, beispielsweise Signale mit einer Frequenz von mehr als 0.9 GHz. Solche Transistoren können beispielsweise durch metallorganische Gasphasenepitaxie oder Molekularstrahlepitaxie hergestellt werden.

Die Ladungsträgerdichte des zweidimensionalen Elektronengases (2-DEG) beeinflusst den Schichtwiderstand innerhalb des 2-DEG sowie den Schwellenwert der Gatespannung eines die genannte Halbleiterstruktur enthaltenen Transistors, ab welcher der Stromfluss innerhalb des 2-DEG einsetzt. Weiterhin wird die Schwellenspannung durch das Oberflächenpotential der Halbleiterstruktur, deren Dicke und der Größe der an der Grenzfläche auftretenden Bandverbiegung beeinflusst. Aus O. Ambacher et al.: Pyroelectric properties of AlGaN/GaN heteroand quantum-well structures, J. Phys.: Condens. Matter 14 (2002) 3399 ist eine Näherungsformel bekannt, mit welcher die Ladungsträgerkonzentration innerhalb des zweidimensionalen Elektronengases in Abhängigkeit des Aluminium-Gehaltes der zweiten Schicht modelliert werden kann.

Für die technische Anwendung der eingangs genannten Transistoren ist es erforderlich, einen solchen Transistor mit einer vorgebbaren Schwellenspannung $U_{th}$ und einem vorgebbaren Schichtwiderstand bereitzustellen. Daher besteht die Aufgabe der vorliegenden Erfindung darin, ein Verfahren zur Bestimmung der Struktur eines Transistors anzugeben, welcher eine vorgebbare Schwellenspannung $U_{th}$ und/oder eine vorgebbare Ladungsträgerdichte $n_s$ aufweist.

Aus der US 2007/0018199 A1 ist ein Gruppe-III-Nitrid-Feldeffekttransistor bekannt. Dieser umfasst eine Kanalschicht, eine Barriereschicht auf der Kanalschicht, eine Ätzstoppschicht auf der Deckschicht, eine dielektrische Schicht auf der Ätzstoppschicht, eine Gate-Ausnehmung, die sich erstreckt die Sperrschicht und einen Gate-Kontakt in der Gate-Aussparung. Die Ätzstoppschicht kann Schäden reduzieren, die mit dem Ausbilden des vertieften Gates verbunden sind, indem die Barriereschicht keinem Trockenätzen ausgesetzt wird. Die Ätzstoppschicht in der Aussparung wird entfernt und die verbleibende Ätzstoppschicht dient als Passivierungsschicht.

Die US 7,224,004 B2 offenbart beim Wachstum einer AlGaN-Schicht mit einer Doppelschichtstruktur eine nicht dotierte AlGaN-Schicht mit einem Al-Gehalt von etwa 15% bis zu einer Dicke von etwa 3 nm zu erzeugen. Darauf wird eine undotierte GaN-Schicht und weiter darauf eine n-dotierte AlGaN-Schicht abgeschieden. Diese weist einen Al-Gehalt von ungefähr 15% und eine Dicke von ungefähr 17 nm auf.

Die Aufgabe wird erfindungsgemäß durch ein Verfahren gemäß Anspruch 1 gelöst.

Die Schwellenspannung $U_{th}$ eines Transistors der eingangs genannten Art sowie dessen Schichtwiderstand können über drei Freiheitsgrade eingestellt werden, nämlich die Schichtdicke und den Aluminiumgehalt der zweiten Schicht und das für den Gate-Kontakt verwendete Metall. Erfindungsgemäß wurde erkannt, dass eine Veränderung der Schichtdicke nicht durch eine Veränderung des Aluminiumgehaltes ausgeglichen werden kann. Dies eröffnet die Möglichkeit, durch Variation der Schichtdicke und des Aluminiumgehaltes einen Transistor mit vorgebbaren Eigenschaften, insbesondere mit vorgebbarer Ladungsträgerkonzentration $n_s$ und Schwellenspannung $U_{th}$ bereitzustellen.

Weiterhin wurde erfindungsgemäß erkannt, dass die Ladungsträgerkonzentration vom Oberflächenpotential der äußersten Schicht abhängt. Daher führt eine Messung der Ladungsträgerkonzentration $n_s$, beispielsweise durch eine Halleffekt-Messung, zu einem ersten Wert, solange die Halbleiterstruktur noch nicht mit einer Gate-Metallisierung versehen ist. Nach Aufbringen der Gate-Metallisierung als vierte Schicht führt eine Messung der Ladungsträgerkonzentration $n_s$, beispielsweise durch eine Halleffekt-Messung, zu einem zweiten Wert, welcher vom ersten Wert verschieden ist. Eine zuverlässige Vorhersage des zweiten Wertes, welcher für den Betrieb des Transistors wesentlich ist, erfordert daher eine Korrektur des ersten Wertes, welche aus der Kenntnis des Oberflächenpotentials heraus möglich ist.

Erfindungsgemäß wird vorgeschlagen, den Einfluss der Gate-Metallisierung auf die Ladungsträgerkonzentration und die Schwellenspannung zu bestimmen, indem die Potentialdifferenz zwischen der Schottky-Barriere und dem Oberflächenpotential der äußersten Schicht der Halbleiterstruktur bestimmt wird. Hierzu kann das erfindungsgemäße Verfahren eine Messung des Oberflächenpotentials der äußersten Schicht der Halbleiterstruktur umfassen. In anderen Ausführungsformen der Erfindung kann das Oberflächenpotential aus Vergleichsversuchen bestimmt werden, welche beispielsweise das Herstellungsverfahren und/oder die Umgebungsbedingungen des Halbleiterwafers zum Zeitpunkt der Messung und/oder während eines vorgebbaren Zeitrahmens vor der Messung berücksichtigen. Auf diese Weise kann durch Anpassen der Schottky-Barriere durch Auswahl der Gate-Metallisierung, durch Auswahl der Schichtdicke d der zweiten und/oder dritten Schicht sowie des Aluminiumgehaltes x der zweiten Schicht ein Transistor mit vorgebbaren Eigenschaften bereitgestellt werden.

Völlig überraschend hat sich gezeigt, dass ein solchermaßen optimierter Transistor eine erhöhte Widerstandsfähigkeit gegenüber einer Fehlanpassung zu nachfolgenden Komponenten aufweist, so dass die Ausfallhäufigkeit eines solchen Transistors bzw. eines damit ausgestatteten Gerätes abnimmt.

In einigen Ausführungsformen der Erfindung kann das Material der vierten Schicht ausgewählt sein aus Silber und/oder Palladium und/oder Nickel und/oder Platin. Auf diese Weise kann die Schottky-Barriere und damit die Schwellenspannung und die Ladungsträgerdichte des Transistors in weiten Bereichen eingestellt werden. So beträgt beispielsweise die Barrierenhöhe der Schottky-Barriere eines Silberkontaktes 0.5 eV, diejenige eines Palladiumkontaktes 0.9 eV, diejenige eines Nickelkontaktes 1.0 eV und die Schottky-Barriere eines Platinkontaktes 1.1 eV.

In einigen Ausführungsformen der Erfindung kann die Gesamtdicke d der zweiten und dritten Schicht zwischen etwa 15 nm und etwa 50 nm gewählt werden. In einigen Ausführungsformen der Erfindung kann der Aluminiumgehalt x der zweiten Schicht zwischen 0,08 und 0,18 gewählt sein. In dem angegebenen Parameterbereich können Transistoren bereitgestellt werden, welche eine Ladungsträgerdichte zwischen $2 \times 10^{12}$ und $9 \times 10^{12}$ cm$^{-2}$ und eine Schwellenspannung $U_{th}$ zwischen 0 und -3 V erreichen.

Nachfolgend soll die Erfindung anhand von Ausführungsbeispielen und Figuren ohne Beschränkung des allgemeinen Erfindungsgedankens näher erläutert werden. Dabei zeigt:

Fig. 1　　einen Querschnitt durch einen erfindungsgemäß vorgeschlagenen Transistor.

Fig. 2　　zeigt ein Flussdiagramm des offenbarten Verfahrens.

Fig. 3　　illustriert die Ladungsträgerdichte eines erfindungsgemäß vorgeschlagenen Transistors in Abhängigkeit des Aluminiumgehaltes der zweiten Schicht.

Fig. 4　　offenbart das Oberflächenpotential $\Phi_B$ der Halbleiterstruktur in Abhängigkeit des Herstellungsverfahrens und des Aluminiumgehaltes x der zweiten Schicht.

Fig. 5　　zeigt die Schwellenspannung $U_{th}$ in Abhängigkeit des Aluminiumgehaltes x für verschiedene Ausführungsformen der vorliegenden Erfindung.

Fig. 6　　zeigt die Leistungsdichte p einer Mehrzahl parallel angeordneter Transistoren für drei unterschiedliche Ausführungsformen der Erfindung.

Fig. 7　　illustriert schematisch die Veränderung der Schwellenspannung $U_{th}$ und der Ladungsträgerdichte $n_s$ bei Veränderung des Aluminiumgehaltes x und/oder der Schichtdicke d.

Fig. 8　　illustriert schematisch, wie durch Variation der Schichtdicke d und des Aluminiumgehaltes x ein Transistor mit vorgebbaren Werten für die Schwellenspannung $U_{th}$ und die Ladungsträgerdichte $n_s$ herstellbar ist.

Fig. 9　　zeigt die Verlustleistung $p_v$ einer Mehrzahl parallel angeordneter Transistoren gemäß der vorliegenden Erfindung für unterschiedliche Stehwellenverhältnisse VSWR.

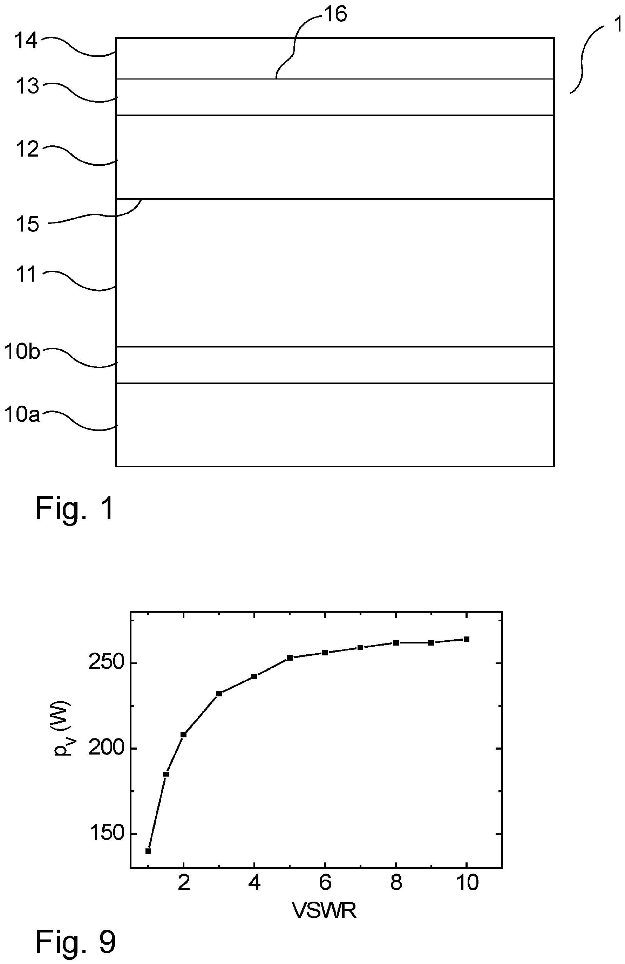

Figur 1 zeigt einen Querschnitt durch einen erfindungsgemäß hergestellten Transistor 1. Der Querschnitt gemäß Fig. 1 beschränkt sich dabei auf den Kanalbereich des Transistors. Die Herstellung angrenzender Source- und Drain-Bereiche ist dem Fachmann geläufig und daher in Fig. 1 nicht weiter erläutert.

Der Transistor 1 ist auf einem Substrat 10a angeordnet. Das Substrat 10a kann beispielsweise Saphir oder Siliziumcarbid enthalten. Auf dem Substrat 10a kann eine optionale Pufferschicht 10b angeordnet sein. Die Pufferschicht 10b kann beispielsweise AlN enthalten. Die Pufferschicht 10b kann eine Dicke von 30 bis 150 nm aufweisen. Die Pufferschicht 10b kann dazu dienen, die Nukleation der darüber liegenden ersten Schicht 11 zu erleichtern. Darüber hinaus kann die Pufferschicht 10b einen vorgebbaren elektrischen Widerstand zwischen der ersten Schicht 11 und dem Substrat 10a bewirken.

Auf der optionalen Pufferschicht 10b oder auf der Oberfläche des Substrates 10a ist die erste Schicht 11 angeordnet. Die erste Schicht 11 enthält GaN. Die erste Schicht 11 kann in einigen Ausführungsformen der Erfindung eine Dicke zwischen 1 μm und 3 μm aufweisen.

Auf der ersten Schicht 11 ist eine zweite Schicht 12 angeordnet. Die zweite Schicht 12 enthält $Al_xGa_{1-x}N$. In einigen Ausführungsformen der Erfindung kann der Aluminium-Gehalt x zwischen 0.08 und 0.18 gewählt sein. In anderen Ausführungsformen der Erfindung kann der Aluminiumgehalt x auch bis auf $x = 0.3$ ansteigen. In einigen Ausführungsformen der Erfindung kann die zweite Schicht 12 eine Dicke von 10 nm bis 45 nm aufweisen.

Auf der zweiten Schicht 12 kann eine optionale dritte Schicht 13 angeordnet sein. Die dritte Schicht 13 kann wiederum GaN oder $Al_yGa_{1-y}N$ enthalten. In diesem Fall ist der Aluminiumgehalt $y$ meist vom Aluminiumgehalt $x$ der zweiten Schicht 12 verschieden, wobei $y$ zwischen 0.05 und 0.30 gewählt sein kann. Die dritte Schicht 13 kann eine Dicke zwischen 2 nm und 10 nm aufweisen. In einigen Ausführungsformen der Erfindung weisen die zweite Schicht 12 und die dritte Schicht 13 zusammen eine Dicke zwischen 15 nm bis etwa 50 nm auf.

Aufgrund der piezoelektrischen Polarisation der ersten Schicht 11, der zweiten Schicht 12 und der optionalen dritten Schicht 13 bildet sich an der Grenzfläche 15 zwischen der ersten Schicht 11 und der zweiten Schicht 12 ein zweidimensionales Elektronengas (2-DEG) aus. Die Ladungsträgerdichte $n_s$ kann durch den Aluminiumgehalt $x$ in der zweiten Schicht 12 bestimmt sein. Darüber hinaus kann die Ladungsträgerdichte $n_s$ an der Grenzfläche zwischen der ersten Schicht 11 und der zweiten Schicht 12 durch ein einwirkendes elektrisches Feld beeinflusst werden. Ein solches elektrisches Feld kann beispielsweise durch ein Oberflächenpotential an der der zweiten Schicht 12 abgewandten Oberfläche 16 der dritten Schicht 13 hervorgerufen sein oder, wenn die dritte Schicht 13 fehlt, durch ein Oberflächenpotential an der der ersten Schicht 11 abgewandten Oberfläche der zweiten Schicht 12.

Um im Betrieb des Transistors 1 ein die Ladungsträgerdichte $n_s$ beeinflussendes elektrisches Feld hervorzurufen, wird auf die Oberfläche 16 der dritten Schicht 13 bzw. auf die Oberfläche der zweiten Schicht 12 eine vierte Schicht 14 aus einem Metall oder einer Legierung aufgebracht. Die vierte Schicht 14 kann in einigen Ausführungsformen der Erfindung eine Schichtdicke von 2 nm bis 30 nm aufweisen. In einigen Ausführungsformen der Erfindung enthält die vierte Schicht Silber und/oder Palladium und/oder Nickel und/oder Platin. Die Anwesenheit der vierten Schicht 14 kann das Oberflächenpotential an der Oberfläche 16 der äußersten Schicht 13 bzw. 12 beeinflussen, so dass die Anwesenheit der vierten Schicht 14 auch die Ladungsträgerkonzentration an der Grenzfläche 15 beeinflusst, wenn keine elektrische Spannung an der vierten Schicht anliegt. Darüber hinaus kann im Betrieb des Transistors 1 an die vierte Schicht 14 ein vorgebbares elektrisches Potential angelegt werden, um die Ladungsträgerkonzentration über ein elektrisches Feld in vorgebbarer Weise zu beeinflussen.

Über die genannten Bestandteile hinaus kann die Pufferschicht 10b, die erste Schicht 11, die zweite Schicht 12, die dritte Schicht 13 und/oder die vierte Schicht 14 weitere Elemente enthalten, entweder als Dotierstoff, um eine bestimmte vorgebbare Leitfähigkeit der Pufferschicht 10b, der ersten Schicht 11, der zweiten Schicht 12, der dritten Schicht 13 und/oder der vierten Schicht 14 einzustellen oder um die Gitterkonstanten der Pufferschicht 10b, der ersten Schicht 11, der zweiten Schicht 12, der dritten Schicht 13 und/oder der vierten Schicht 14 zu beeinflussen oder als unvermeidbare Verunreinigungen.

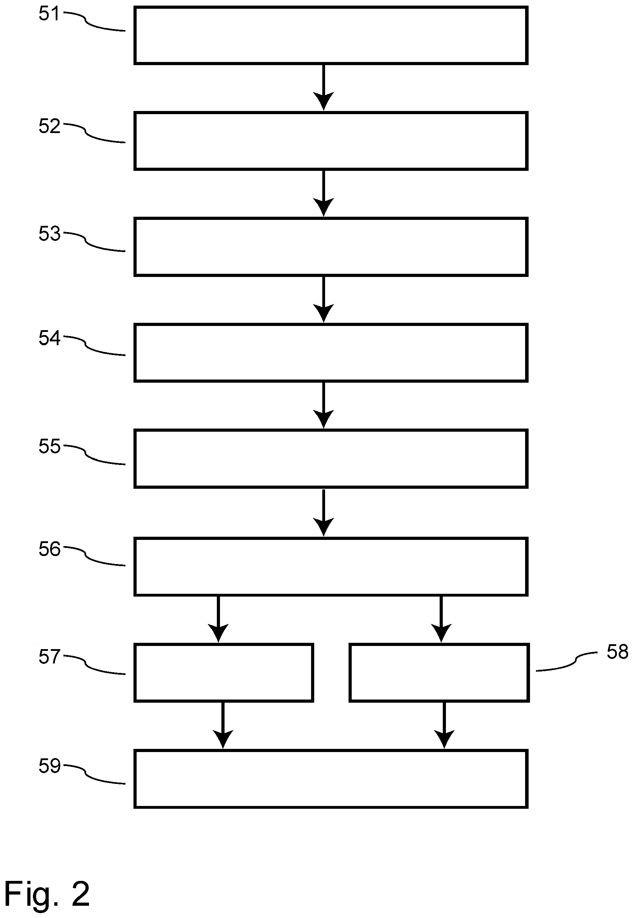

Figur 2 zeigt ein Flussdiagramm des erfindungsgemäß vorgeschlagenen Verfahrens zur Bestimmung der Struktur zumindest eines Transistors 1. Im ersten Verfahrensschritt 51 wird zunächst die Schichtdicke der zweiten Schicht 12 sowie die Schichtdicke der optionalen dritten Schicht 13 festgelegt, welche Einfluss auf die Ladungsträgerkonzentration $n_s$ an der Grenzfläche 15 und auf die Schwellenspannung $U_{th}$ haben.

Im zweiten Verfahrensschritt 52 wird der Aluminiumgehalt $x$ der zweiten Schicht 12 festgelegt, so dass eine vorgebbare Ladungsträgerkonzentration $n_s$ und damit ein vorgebbarer Schichtwiderstand des 2-DEG innerhalb der Grenzfläche 15 erreicht wird.

Im dritten Verfahrensschritt 53 wird zumindest die erste Schicht 11, die zweite Schicht 12 und, falls vorhanden, die dritte Schicht 13 hergestellt. In einigen Ausführungsformen der Erfindung kann der Verfahrensschritt 53 auch das Herstellen der Pufferschicht 10b auf dem Substrat 10a mit umfassen. Die Herstellung der genannten Schichten kann beispielsweise mittels einer Molekularstrahlepitaxie erfolgen. In anderen Ausführungsformen der Erfindung kann die Abscheidung der Schichten aus einer aktivierten Gasphase erfolgen, beispielsweise mittels MOCVD oder MOVPE.

Im vierten Verfahrensschritt 54 wird zumindest die Ladungsträgerdichte $n_s$ und optional die Beweglichkeit $\mu$ des 2-DEG bestimmt. Hierzu kann beispielsweise in an sich bekannter Weise eine Halleffekt-Messung herangezogen werden. Da die Ladungsträgerdichte durch das Oberflächenpotential der Oberfläche 16 der äußersten Schicht 13 beeinflusst wird, kann es zur Interpretation der Ergebnisse der Halleffekt-Messung erforderlich sein, auch das Oberflächenpotential $\Phi_B$ der äußersten Schicht zu messen, beispielsweise der dritten Schicht 13. Dies kann beispielsweise in an sich bekannter Weise durch Photoreflexion erfolgen.

Da das Oberflächenpotential $\Phi_\beta$ vom Herstellungsverfahren abhängen kann, welches im Schritt 53 angewendet wurde und/oder von dem in Schritt 52 festgelegten Aluminium-Gehalt, kann die Ladungsträgerdichte $n_s$ nach der Herstellung der ersten Schicht 11, der zweiten Schicht 12 und der dritten Schicht 13 auch vom Herstellungsverfahren und/oder dem Aluminiumgehalt abhängen. Die Abhängigkeit der Ladungsträgerdichte $n_s$ vom Aluminiumgehalt x ergibt sich dabei insbesondere aus parasitären Aluminium-Verunreinigungen, welche in die dritte Schicht 13 eingebaut werden. Daher kann das Oberflächenpotential $\Phi_\beta$ bzw. dessen Einfluss auf die gemessene Ladungsträgerdichte $n_s$ auch durch Interpolation von Vergleichsversuchen an gleichartigen Halbleiterstrukturen ermittelt werden.

In anderen Ausführungsformen der Erfindung kann das Bestimmen des Oberflächenpotentials und/oder der Ladungsträgerdichte im vierten Verfahrensschritt 54 auch mittels einer Berechnung und/oder durch Rückgriff auf tabellierte Messwerte für gleichartige Halbleiterstrukturen erfolgen. In diesem Fall kann die Ladungsträgerdichte und/oder das Oberflächenpotential für eine Vielzahl gleichartiger Transistoren 1 in besonders einfacher Weise bestimmt werden.

Im fünften Verfahrensschritt 55 wird ein Gatematerial für die vierte Schicht 14 ausgewählt. Insbesondere kann das Material der vierten Schicht Silber und/oder Palladium und/oder Nickel und/oder Platin enthalten. Durch die Auswahl des Materials der vierten Schicht 14 wird das Oberflächenpotential an der Grenzfläche zwischen der äußersten Schicht, beispielsweise der dritten Schicht 13, und der vierten Schicht 14 auf die Barrierenhöhe der jeweiligen Schottky-Barriere festgelegt. In einigen Ausführungsformen der Erfindung beträgt die Schottky-Barriere 0.5 eV, wenn die vierte Schicht im wesentlichen Silber enthält. Die Schottky-Barriere beträgt 0.9 eV, wenn die vierte Schicht im Wesentlichen Palladium enthält. In einer anderen Ausführungsform der Erfindung beträgt die Schottky-Barriere 1.0 eV, wenn das Material der vierten Schicht im Wesentlichen Nickel enthält. Sofern das Material der vierten Schicht im Wesentlichen Platin enthält, beträgt die Schottky-Barriere 1.1 eV. Selbstverständlich ist das Material der vierten Schicht nicht auf die genannten Materialien beschränkt. In einigen Ausführungsformen der Erfindung können auch Legierungen oder Mehrschichtsysteme für die vierte Schicht 14 verwendet werden.

Im sechsten Verfahrensschritt 56 kann nun der Einfluss der vierten Schicht auf die Ladungsträgerdichte $n_s$ des 2-DEG bestimmt werden. Die Ladungsträgerdichte $n_s$ wird durch den Aluminiumgehalt $x$ der zweiten Schicht, die Dicke der zweiten Schicht 12 und der dritten Schicht 13 sowie das anliegende elektrische Feld bestimmt. Da der Aluminiumgehalt x und die Schichtdicken d bereits in den ersten drei Verfahrensschritten 51, 52 und 53 festgelegt wurden, muss im sechsten Verfahrensschritt 56 lediglich noch die Änderung $\Delta\Phi_B$ des Oberflächenpotentials $\Phi_\beta$ berücksichtigt werden. Diese Änderung $\Delta\Phi_B$ des Oberflächenpotentials entspricht der Differenz zwischen der Schottky-Barriere des ausgewählten Gatemetalls und dem in Verfahrensschritt 54 bestimmten Oberflächenpotential der äußersten Schicht. Die Änderung der Ladungsträgerdichte $\Delta n_s$ kann dabei in einigen Ausführungsformen der Erfindung durch folgende Gleichung modelliert werden:

$$\Delta\Phi_B = \frac{e^2 \cdot d}{\varepsilon \cdot \varepsilon_0}\Delta n_s$$

In den nachfolgenden Verfahrensschritten 57 und 58 wird die Schwellenspannung $U_{th}$ des Transistors 1 bestimmt. Meist wird die einfache Bestimmung der Schwellenspannung $U_{th}$ ausreichen, so dass entweder der Verfahrensschritt 57 oder der Verfahrensschritt 58 ausgeführt wird. In einigen Ausführungsformen der Erfindung können jedoch zur Plausibilisierung oder zur Erhöhung der Genauigkeit beide Verfahrensschritte 57 und 58 ausgeführt werden.

Im Verfahrensschritt 57 ist vorgesehen, die Schwellenspannung $U_{th}$ in Abhängigkeit des Oberflächenpotentials $\Phi_B$ nach Aufbringen der vierten Schicht 14 und der Ladungsträgerdichte $n_s$ nach Aufbringen der vierten Schicht 14 gemäß folgender Gleichung zu modellieren:

$$U_{th} = \frac{\Phi_B}{e} - \frac{\Delta E_c}{e} - \frac{e \cdot n_s \cdot d}{\varepsilon \cdot \varepsilon_0}$$

Dabei bezeichnet $e$ die Elementarladung, $\Delta E_C$ die Bandverbiegung an der Grenzfläche 15, $d$ die Schichtdicke der zweiten Schicht 12 und der dritten Schicht 13 sowie $\varepsilon$ und $\varepsilon_0$ die relative und die Vakuumpermetivität.

Im Verfahrensschritt 58 kann ein vereinfachtes Verfahren zur Ermittlung der Schwellenspannung $U_{th}$ des Transistors in Abhängigkeit der Änderung des Oberflächenpotentials $\Delta\Phi_B$ nach Aufbringen der vierten Schicht 14 erfolgen:

$$U_{th} = U_{th}^0 + \frac{2 \cdot \Delta\Phi_B}{e}$$

Hierin bezeichnet $e$ wiederum die Elementarladung und $U_{th}^0$ bezeichnet die aus den in Verfahrensschritt 54 ermittelten Messwerten berechnete Schwellenspannung. $U_{th}^0$ kann in an sich bekannter Weise ermittelt werden, beispielsweise wie in O. Ambacher et al.: Pyroelectric properties of AlGaN/GaN heteroand quantumwell structures, J. Phys.: Condens. Matter 14 (2002) 3399 beschrieben.

Sofern die in Verfahrensschritt 56, 57 und/oder 58 ermittelten Werte für die Ladungsträgerkonzentration $n_s$ und die Schwellenspannung $U_{th}$ den gewünschten Sollwerten entsprechen, kann im Verfahrensschritt 59 das in Verfahrensschritt 55 ausgewählte Gatematerial als vierte Schicht 14 auf die Oberfläche der äußersten Schicht 12 oder 13 aufgebracht werden. Sofern die ermittelten Werte der Schwellenspannung und der Ladungsträgerkonzentration von den gewünschten Sollwerten abweichen, können die Verfahrensschritte 55, 56, 57 und/oder 58 solange wiederholt werden, bis ein Gatematerial gefunden wurde, welches die gewünschten Eigenschaften des Transistors bereitstellen kann.

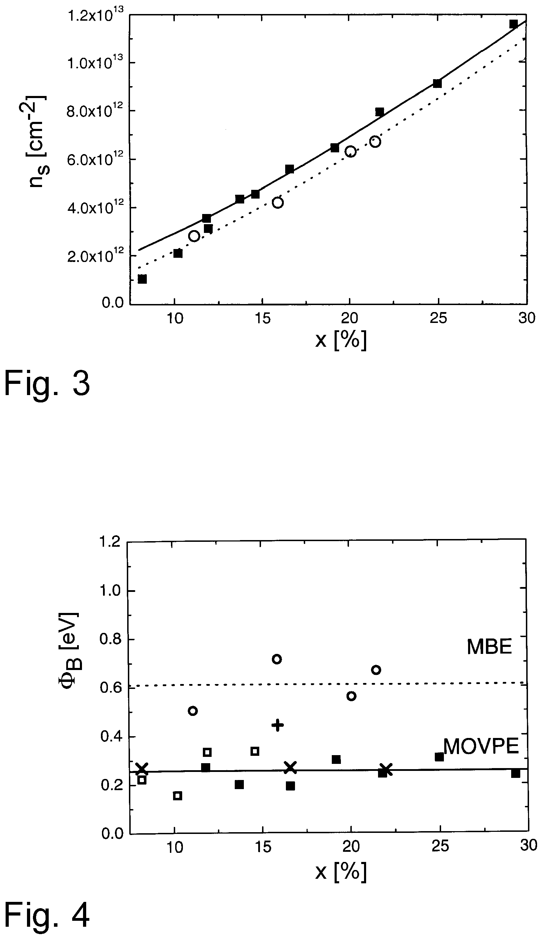

Die Figuren 3, 4, 5, 6 und 9 zeigen Messwerte, welche an Transistoren mit dem in Figur 1 dargestellten Schichtaufbau gewonnen wurden. Figur 3 zeigt den Einfluss des Herstellungsverfahrens der ersten Schicht 11, der zweiten Schicht 12 und der dritten Schicht 13 auf die Ladungsträgerkonzentration $n_s$. In Fig. 3 ist die Ladungsträgerkonzentration $n_s$ auf der Ordinate dargestellt und der Aluminiumgehalt x in Atom-% auf der Abszisse. Die Messwerte gemäß Fig. 3 wurden mittels einer Halleffekt-Messung aufgenommen, ohne dass eine vierte Schicht 15 auf der Oberfläche 16 der dritten Schicht 13 angeordnet gewesen wäre. Hierbei sind die Werte für mittels Molekularstrahlepitaxie hergestellte Halbleiterstrukturen als Kreise dargestellt. Die gefüllten Quadrate repräsentieren Messwerte, welche an mittels MOVPE hergestellte Halbleiterstrukturen aufgenommen wurden.

Weiterhin sind theoretisch bestimmte Verläufe der Ladungsträgerdichte eingetragen, welche gemäß O. Ambacher et al.: Pyroelectric properties of AlGaN/GaN hetero- and quantum-well structures, J. Phys.: Condens. Matter 14 (2002) 3399 berechnet wurden. Hierbei zeigt sich, dass die Ladungsträgerdichte $n_s$ innerhalb des 2-DEG für Halbleiterstrukturen, welche mittels MBE erhalten wurden, niedriger ist als Ladungsträgerdichten $n_s$ von vergleichbaren Halbleiterstrukturen, welche mittels MOVPE hergestellt wurden. Erfindungsgemäß wurde erkannt, dass dieser Unterschied in der Ladungsträgerdichte $n_s$ kann auf einen Unterschied im Oberflächenpotential der dritten Schicht 13 zurückgeführt werden kann. Das Oberflächenpotential $\Phi_B$ beträgt demnach 0.61 eV für die mittels MBE hergestellten Halbleiterstrukturen und 0.26 eV für mittels MOVPE hergestellte Halbleiterstrukturen.

Der Einfluss des Herstellungsverfahrens auf das Oberflächenpotential $\Phi_\beta$ ist auch in Fig. 4 dargestellt. Figur 4 zeigt wiederum den Aluminiumgehalt $x$ auf der Abszisse und das Oberflächenpotential $\Phi_\beta$ auf der Ordinate. Hierbei bezeichnen die gefüllten Quadrate wiederum Messwerte, welche mittels Halleffekt-Messungen an Halbleiterstrukturen erhalten wurden, welche mittels MOVPE hergestellt wurden. Die Kreise bezeichnen Messwerte des Oberflächenpotentials, welche mittels Halleffekt-Messungen an Halbleiterstrukturen erhalten wurden, welche mittels MBE hergestellt wurden. Mittels CV-Profilen ermittelte Werte des Oberflächenpotentials für Halbleiterstrukturen, welche mittels MOVPE hergestellt wurden, sind durch ungefüllte Quadrate dargestellt. Daneben zeigt Fig. 4 Ergebnisse von Messungen der Photoreflexion als Kreuze. Dabei sind die an mittels MOVPE hergestellten Halbleiterstrukturen ermittelten Werte durch gedrehte Kreuze dargestellt.

Somit bestätigen auch die Fig. 4 dargestellten Messwerte, dass das Oberflächenpotential $\Phi_B$ der Halbleiterstrukturen vom verwendeten Herstellungsverfahren abhängt. Dadurch beeinflusst das Herstellungsverfahren die gemessene Ladungsträgerkonzentration $n_s$, solange kein Gatematerial als vierte Schicht 14 auf die Oberfläche 16 aufgebracht ist.

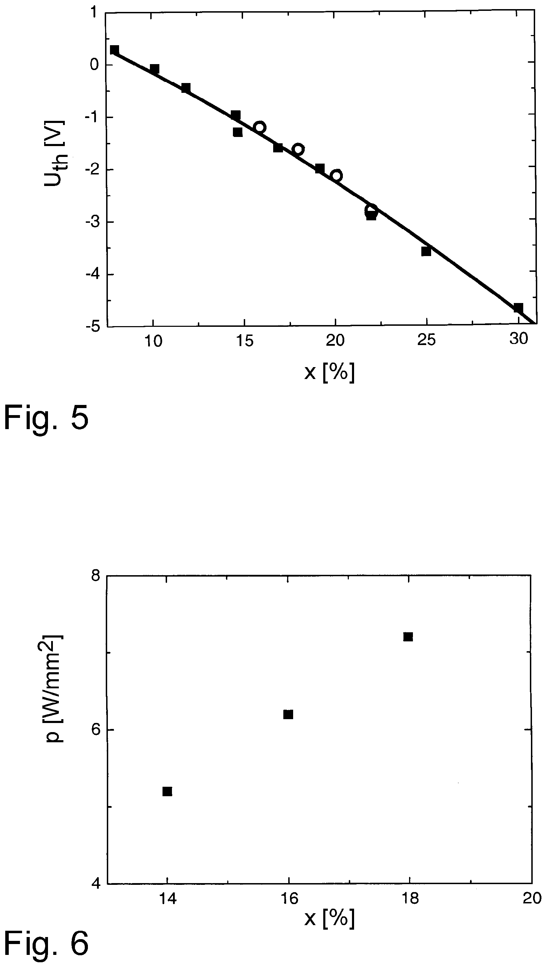

Figur 5 zeigt die Schwellenspannung $U_{th}$ eines Transistors, welcher die in Fig. 1 dargestellte Halbleiterstruktur enthält. Abweichend von den Halbleiterstrukturen, welche für die in den Figuren 3 und 4 dargestellten Messungen verwendet wurden, weisen die für die Messungen in Fig. 5 verwendeten Halbleiterstrukturen die in Fig. 1 dargestellte vierte Schicht 14 als Gateelektrode auf.

In Fig. 5 sind wiederum die an mittels MOVPE hergestellten Halbleiterstrukturen gewonnenen Messwerte als Quadrate dargestellt und die Messwerte der mittels MBE hergestellten Halbleiterstrukturen als Kreise. Aus Fig. 5 ist ersichtlich, dass die Schwellenspannung $U_{th}$ und damit auch die Ladungsträgerdichte $n_s$ durch Aufbringen der vierten Schicht 14 unabhängig vom für die Herstellung der Halbleiterstruktur verwendeten Herstellungsverfahren wird. Dies bedeutet, dass das Oberflächenpotential $\Phi_B$ an der Oberfläche 16 durch das Aufbringen der vierten Schicht 14 auf den Wert der Schottky-Barriere zwischen der vierten Schicht 14 und der dritten Schicht 13 festgelegt wird. Erfindungsgemäß wurde erkannt, dass die Schwellenspannung $U_{th}$ eines Transistors 1 sowie dessen Ladungsträgerdichte $n_s$ nur durch die Kombination von erster Schicht 11, zweiter Schicht 12, dritter Schicht 13 und vierter Schicht 14 festgelegt wird. Sofern zur Prozesskontrolle Messungen der Ladungsträgerdichte $n_s$ und/oder der Schwellenspannung $U_{th}$ an der ersten Schicht 11, der zweiten Schicht 12 und der dritten Schicht 13 durchgeführt werden, so hängen diese Ergebnisse jedoch vom Oberflächenpotential der dritten Schicht 13 und damit vom Herstellungsverfahren ab.

In einem Ausführungsbeispiel soll ein Leistungsverstärker für ein hochfrequentes Signal hergestellt werden. Ein solcher Leistungsverstärker kann beispielsweise in einer Basisstation eines Mobilfunknetzwerkes eingesetzt werden. Der Leistungsverstärker soll an einer Betriebsspannung von 50 V betrieben werden. Der Leistungsverstärker umfasst eine Mehrzahl parallel angeordneter Transistoren, welche jeweils einen Aufbau gemäß Fig. 1 aufweisen. Die Mehrzahl von Transistoren kann beispielsweise 80 bis 120 Transistoren umfassen. Die Mehrzahl von Transistoren kann in einer Ausführungsform der Erfindung monolithisch auf einem einzigen Substrat 10a integriert sein. Der Abstand der einzelnen Transistoren kann etwa 50 μm bis etwa 150 μm betragen. Daraus ergibt sich eine Gatebreite der Anordnung von etwa 25 mm bis etwa 40 mm. Die Gatelänge der Transistoren kann etwa 0.4 μm bis etwa 1.0 μm betragen.

Der Leistungsverstärker erzeugt aus dem Betriebs-Gleichstrom ein hochfrequentes Ausgangssignal. Unter einem hochfrequenten Ausgangssignal im Sinne der vorliegenden Erfindung wird dabei ein Ausgangssignal verstanden, welches eine Frequenz von mehr als 0.85 GHz, oder eine Frequenz von mehr als 2 GHz, oder eine Frequenz von mehr als 5 GHz aufweist. Der Teil des aufgenommenen Gleichstroms, welcher vom Leistungsverstärker nicht in das hochfrequente Ausgangssignal gewandelt wird, wird in Verlustleistung $p_V$ umgewandelt und muss als Wärme abgeführt werden. Die von dem Leistungsverstärker umgesetzte elektrische Leistung kann in einigen Ausführungsbeispielen mehr als 5 W, mehr als 10 W oder mehr als 30 W betragen.

Wie in Fig. 6 dargestellt ist, steigt mit zunehmendem Aluminiumgehalt $x$ der zweiten Schicht die Ladungsträgerkonzentration $n_s$ und damit die Leistungsdichte $p$ an. Zur Begrenzung der thermischen Last ist daher ein niedriger Aluminiumgehalt $x$ vorteilhaft. Gemäß dem in Verfahrensschritt 57 nach Fig. 2 erläuterten Zusammenhang steigt dadurch jedoch die Schwellenspannung $U_{th}$ an und kann unerwünscht hohe Werte annehmen.

Fig 9 zeigt die Verlustleistung $p_V$ einer Mehrzahl parallel angeordneter Transistoren gemäß der vorliegenden Erfindung für unterschiedliche Stehwellenverhältnisse *VSWR*. Die Mehrzahl von Transistoren kann einen Aufbau aufweisen, wie in Zusammenhang mit Figur 5 beschrieben. Das Stehwellenverhältnis *VSWR* stellt dabei ein Maß für die Fehlanpassung der Transistoren an die mit den jeweiligen Ausgängen verbundene Komponente dar. Bei einem *VSWR* von 1:1 ist dabei keine Fehlanpassung vorhanden und die Verlustleistung und damit die Wärmeentwicklung ist minimal. Mit zunehmendem *VSWR,* beispielsweise auf Werte von 2:1, 3:1, 4:1, 5:1, 6:1 oder 10:1 nimmt die Fehlanpassung zu und ein immer größer werdender Anteil der aufgenommenen elektrischen Leistung wird in Verlustleistung $p_V$ gewandelt, welche das Halbleiterbauelement schädigen kann.

Wie aus Figur 9 ersichtlich, kann ein mit dem erfindungsgemäßen Verfahren optimiertes Halbleiterbauelement auch bei einer großen Fehlanpassung bzw. bei einem *VSWR* von 10:1 bei einer Betriebsspannung $V_{DS}$ von 50 V betrieben werden, obgleich dadurch die Verlustleistung um einen Faktor 1,5 bis 2,0 gegenüber dem Regelbetrieb bei einem *VSWR* von 1:1 ansteigt. Dadurch kann die Zuverlässigkeit des Halbleiterbauelementes und eines mit dem Bauelement ausgestatteten Gerätes verbessert werden. Die Messwerte gemäß Figur 9 wurden dabei in einem Betriebspunkt des Transistors aufgenommen, bei welchem der Transistor in der Gainkompression ist. In einigen Ausführungsformen der Erfindung kann dies der P3db-Punkt sein. In einer anderen Ausführungsform der Erfindung kann der Transistor im P1db-Punkt sein.

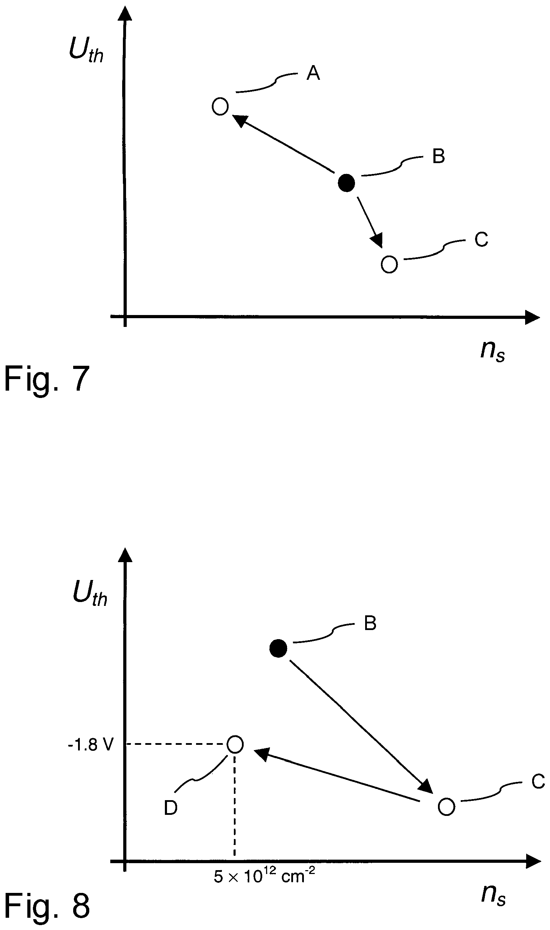

Figur 7 erläutert schematisch den Zusammenhang zwischen der Schwellenspannung $U_{th}$ auf der Ordinate und der Ladungsträgerdichte $n_s$ auf der Abszisse für verschiedene Werte des Aluminiumgehaltes und der Schichtdicke $d$ der zweiten Schicht 12 und der dritten Schicht 13. Beispielsweise repräsentiert der Punkt A in Fig. 7 eine Halbleiterstruktur mit einem Aluminiumgehalt von $x = 0{,}14$ und einer Schichtdicke $d = 22$ nm.

Ausgehend von A kann durch Erhöhen des Aluminiumgehaltes auf $x = 0{,}18$ bei unveränderter Schichtdicke $d = 22$ nm der Punkt B erreicht werden. Die Halbleiterstruktur B zeichnet sich dadurch aus, dass die Schwellenspannung $U_{th}$ absinkt, bei gleichzeitigem Anstieg der Ladungsträgerkonzentration $n_s$.

Durch Vergrößern der Dicke auf d = 30 nm bei unverändertem Aluminiumgehalt $x = 0{,}18$ wird der Punkt C erreicht. Der Punkt C beschreibt eine Halbleiterstruktur mit weiter verringerter Schwellenspannung $U_{th}$ bei geringfügig größerer Ladungsträgerdichte $n_s$. Es ist insbesondere darauf hinzuweisen, dass eine Veränderung der Schichtdicke $d$ nicht durch eine Veränderung des Aluminiumgehaltes $x$ kompensiert werden kann. Auf diese Weise können durch entsprechende Wahl der Schichtdicke $d$ und des Aluminiumgehaltes x gleichzeitig eine niedrige Ladungsträgerdichte $n_s$ und eine hinreichend niedrige Schwellenspannung $U_{th}$ realisiert werden, wie dies in Zusammenhang mit Fig. 8 näher erläutert wird.

Gemäß Fig. 8 soll ein Transistor 1 mit einer Schwellenspannung $U_{th}$ von -1,8 V und einer Ladungsträgerdichte $n_s$ von $5 \times 10^{12}$ cm$^{-2}$ hergestellt werden. Der Transistor 1 mit den gewünschten Eigenschaften ist in Fig. 8 durch den Punkt D bezeichnet.

Ausgehend von Punkt B mit einem Aluminiumgehalt von $x = 18$ % und einer Schichtdicke d = 22 nm wird zunächst die Schichtdicke auf $d = 30$ nm bei unverändertem Aluminiumgehalt von $x = 0{,}18$ erhöht. Auf diese Weise wird eine Halbleiterstruktur erhalten, deren Eigenschaften in Fig. 8 mit C bezeichnet sind.

Die Halbleiterstruktur C weist eine Schwellenspannung auf, welche unterhalb der Schwellenspannung von -1,8 V liegt. Weiterhin ist die Ladungsträgerdichte $n_s$ und damit die Verlustleistung des Transistors größer als der gewünschte Sollwert.

Durch Verringern des Aluminiumgehaltes auf $x = 0{,}12$ bei unveränderter Schichtdicke von $d = 30$ nm ergibt sich eine starke Reduktion der Ladungsträgerdichte $n_s$ bei gleichzeitig nur mäßigem Anstieg der Schwellenspannung $U_{th}$. Auf diese Weise können die gewünschten, in Punkt D dargestellten Eigenschaften des Transistors 1 erhalten werden. Dabei ist darauf hinzuweisen, dass die Schwellenspannung $U_{th}$ erst durch die Auswahl des Gatemetalls festgelegt wird, wie vorstehend in Zusammenhang mit Fig. 2 beschrieben. Erfindungsgemäß können demnach durch Auswahl der Schichtdicke $d,$ des Aluminiumgehaltes $x$ und des Gatematerials Transistoren mit den gewünschten Eigenschaften hergestellt werden.

Selbstverständlich kann das in der vorstehenden Beschreibung offenbarte Lösungsprinzip auch für die Optimierung anderer Parameter eines Transistors herangezogen werden. Die vorstehende Beschreibung ist daher nicht als beschränkend, sondern als erläuternd anzusehen. Die nachfolgenden Ansprüche sind so zu verstehen, dass ein genanntes Merkmal in zumindest einer Ausführungsform der Erfindung vorhanden ist. Dies schließt die Anwesenheit weiterer Merkmale nicht aus. Sofern die Ansprüche und die Beschreibung "erste", "zweite", "dritte" und "vierte" Merkmale definieren, so dient diese Bezeichnung der Unterscheidung gleichartiger Merkmale, ohne eine Rangfolge festzulegen.

**Patentansprüche**

1. Verfahren zur Bestimmung der Struktur zumindest eines Transistors (1), welcher zumindest eine erste Schicht (11), eine zweite Schicht (12) und eine vierte Schicht (14) enthält, wobei die vierte Schicht (14) auf der zweiten Schicht (12) und die zweite Schicht (12) auf der ersten Schicht (11) angeordnet ist, die erste Schicht (11) GaN enthält, die zweite Schicht (12) $Al_xGa_{1-x}N$ und die vierte Schicht (14) ein Metall oder eine Legierung enthält, wobei das Verfahren die folgenden Schritte enthält:

    - Festlegen (51) der Schichtdicke $d$ der zweiten Schicht (12),
    - Festlegen (52) des Aluminium-Gehaltes $x$ der zweiten Schicht (12),
    - Herstellen (53) von zumindest der zweiten Schicht (12) und der ersten Schicht (11),
    - Bestimmen (54) des Oberflächenpotentials $\Phi_B$ und der Ladungsträgerdichte $n_s$ und der Ladungsträgerbeweglichkeit $\mu$ und
    - Auswählen des Materials der vierten Schicht (14) in Abhängigkeit vom bestimmten Oberflächenpotential $\Phi_B$ und der Ladungsträgerdichte $n_s$, wobei
    - ein Zusammenhang zwischen einer Änderung $\Delta\Phi_B$ des Oberflächenpotentials durch das Aufbringen der vierten Schicht (14) und einer Änderung $\Delta n_s$ der Ladungsträgerdichte durch folgende Gleichung modelliert wird (56):

$$\Delta\Phi_B = \frac{e^2 \cdot d}{\varepsilon \cdot \varepsilon_0} \Delta n_s$$
.

2. Verfahren nach Anspruch 1, **dadurch gekennzeichnet, dass** das Material der vierten Schicht (14) ausgewählt wird aus Silber und/oder Palladium und/oder Nickel und/oder Platin und/oder dass der Aluminium-Gehalt $x$ zwischen 0,08 und 0,18 gewählt wird.

3. Verfahren nach Anspruch 1 oder 2, **dadurch gekennzeichnet, dass** der Transistor weiterhin eine dritte Schicht (13) enthält, welche GaN enthält und zwischen der zweiten Schicht (12) und der vierten Schicht (14) angeordnet ist, wobei die vierte Schicht (14) auf der dritten Schicht (13), die dritte Schicht (13) auf der zweiten Schicht (12) und die zweite Schicht (12) auf der ersten Schicht (11) angeordnet ist.

4. Verfahren nach einem der Ansprüche 1 bis 3, bei welchem die Dicke der zweiten Schicht (12) vergrößert wird, um die Schwellenspannung $U_{th}$ des Transistors (1) abzusenken und die Dicke der zweiten Schicht (12) verkleinert wird, um die Schwellenspannung $U_{th}$ des Transistors (1) anzuheben.

5. Verfahren nach einem der Ansprüche 1 bis 4, bei welchem der Aluminium-Gehalt x der zweiten Schicht (12) vergrößert wird, um die Schwellenspannung $U_{th}$ des Transistors (1) abzusenken oder die Ladungsträgerdichte $n_s$ anzuheben und der Aluminium-Gehalt x der zweiten Schicht (12) verkleinert wird um die Schwellenspannung $U_{th}$ des Transistors (1) anzuheben oder die Ladungsträgerdichte $n_s$ abzusenken.

6. Verfahren nach einem der Ansprüche 1 bis 5, bei welchem die Auswahl des Materials der vierten Schicht so erfolgt, dass die Schwellenspannung $U_{th}$ des Transistors (1) zwischen -4.5 V und -1.0 V liegt.

7. Verfahren nach einem der Ansprüche 1 bis 6, bei welchem eine Halleffekt-Messung und/oder eine Messung der Photoreflexion durchgeführt werden.

8. Verfahren nach einem der Ansprüche 1 bis 7, bei welchem die Schwellenspannung $U_{th}$ in Abhängigkeit des Oberflächenpotentials $\Phi_B$ nach Aufbringen der vierten Schicht (14) und der Ladungsträgerdichte $n_s$ wie folgt modelliert wird (57):

$$U_{th} = \frac{\Phi_B}{e} - \frac{\Delta E_c}{e} - \frac{e \cdot n_s \cdot d}{\varepsilon \cdot \varepsilon_0}$$

9. Verfahren nach Anspruch 1 bis 8, bei welchem die Schwellenspannung $U_{th}$ in Abhängigkeit der Änderung des Oberflächenpotentials $\Delta\Phi_B$ nach Aufbringen der vierten Schicht (14) wie folgt bestimmt wird (58):

$$U_{th} = U_{th}^0 + \frac{2 \cdot \Delta\Phi_B}{e}$$

**Claims**

1. Method for determining the structure of at least one transistor (1), comprising at least a first layer (11), a second layer (12) and a fourth layer (14), wherein the fourth layer (14) is disposed on the second layer (12) and the second layer (12) is disposed on the first layer (11), the first layer 11) comprises GaN, the second layer (12) contains $Al_xGa_{1-x}N$ and the fourth layer (14) a metal or an alloy, wherein the method comprises the following steps:

    - setting (51) the layer thickness d of the second layer (12),
    - setting (52) the aluminum content $x$ of the second layer (12),
- producing (53) at least the second layer (12) and the first layer (11),
- determining (54) the surface potential $\Phi_B$ and the charge carrier density $n_s$ and the charge carrier motility $\mu$, and
- selecting the material of the fourth layer (14) on the basis of the determined surface potential $\Phi_B$ and the charge carrier density $n_s$, wherein
- a connection between a change $\Delta\Phi_B$ in the surface potential by applying the fourth layer (14) and a change $\Delta n_s$ in the charge carrier density is established by the following equation (56):

$$\Delta\Phi_B = \frac{e^2 \cdot d}{\varepsilon \cdot \varepsilon_0}\Delta n_s \ .$$

2. Method according to claim 1, **characterized in that** the material of the fourth layer (14) is selected from silver and/or palladium and/or nickel and/or platinum and/or **in that** the aluminum content $x$ is selected between 0.08 and 0.18.

3. Method according to claim 1 or 2, **characterized in that** the transistor also comprises a third layer (13) which contains GaN and is disposed between the second layer (12) and the fourth layer (14), wherein the fourth layer (14) is disposed on the third layer (13), the third layer (13) is disposed on the second layer (12) and the second layer (12) is disposed on the first layer (11).

4. Method according to any of claims 1 to 3, in which the thickness of the second layer (12) is increased to lower the threshold voltage $U_{th}$ of the transistor (1) and the thickness of the second layer (12) is reduced to raise the threshold voltage $U_{th}$ of the transistor (1).

5. Method according to any of claims 1 to 4, in which the aluminum content $x$ of the second layer (12) is increased to lower the threshold voltage $U_{th}$ of the transistor (1) or to raise the charge carrier density $n_s$ and the aluminum content $x$ of the second layer (12) is reduced to raise the threshold voltage $U_{th}$ of the transistor (1) or to lower the charge carrier density $n_s$.

6. Method according to any of claims 1 to 5, in which the material of the fourth layer is selected in such a way that the threshold voltage $U_{th}$ of the transistor (1) is between -4.5 V and -1.0 V.

7. Method according to any of claims 1 to 6, in which a Hall-effect measurement and/or a measurement of the photo-reflection are carried out.

8. Method according to any of claims 1 to 7, in which the threshold voltage $U_{th}$ is modeled on the basis of the surface potential $\Phi_B$ after applying the fourth layer (14) and of the charge carrier density $n_s$ as follows (57):

$$U_{th} = \frac{\Phi_B}{e} - \frac{\Delta E_c}{e} - \frac{e \cdot n_s \cdot d}{\varepsilon \cdot \varepsilon_0}$$

9. Method according to claims 1 to 8, in which the threshold voltage $U_{th}$ is determined on the basis of the change in the surface potential $\Delta\Phi_B$ after applying the fourth layer (14) as follows (58):

$$U_{th} = U_{th}^0 + \frac{2 \cdot \Delta\Phi_B}{e}$$

## Revendications

1. Procédé de détermination de la structure d'au moins un transistor (1) qui comprend au moins une première couche (11), une deuxième couche (12) et une quatrième couche (14), la quatrième couche (14) étant disposée sur la deuxième couche (12) et la deuxième couche (12) sur la première couche (11), la première couche (11) contenant du GaN, la deuxième couche (12) du $Al_xGa_{1-x}$,N et la quatrième couche (14) un métal ou un alliage, le procédé comprenant les étapes suivantes consistant à :

   - déterminer (51) l'épaisseur de couche $d$ de la deuxième couche (12),
   - déterminer (52) la teneur en aluminium $x$ de la deuxième couche (12),
   - réaliser (53) au moins la deuxième couche (12) et la première couche (11),
   - déterminer (54) le potentiel de surface $\Phi_B$ et la densité des porteurs de charge $n_s$ et la mobilité des porteurs de charge $\mu$ et
   - sélectionner le matériau de la quatrième couche (14) en fonction du potentiel de surface $\Phi_B$ déterminé et de la densité des porteurs de charge $ns$,
   - une relation entre une variation $\Delta\Phi_B$ du potentiel de surface par l'application de la quatrième couche (14) et une variation $\Delta n_s$ de la densité des porteurs de charge étant modélisée (56) par l'équation suivante :

$$\Delta\Phi_B = \frac{e^2 \cdot d}{\varepsilon \cdot \varepsilon_0}\Delta n_s \ .$$

2. Procédé selon la revendication 1, **caractérisé en ce**

**que** le matériau de la quatrième couche (14) est sélectionné parmi l'argent et/ou le palladium et/ou le nickel et/ou le platine et/ou que la teneur en aluminium x est choisie entre 0,08 et 0,18.

3. Procédé selon la revendication 1 ou 2, **caractérisé en ce que** le transistor comprend en outre une troisième couche (13) qui contient du GaN et est disposée entre la deuxième couche (12) et la quatrième couche (14), la quatrième couche (14) étant disposée sur la troisième couche (13), la troisième couche (13) sur la deuxième couche (12) et la deuxième couche (12) sur la première couche (11).

4. Procédé selon l'une des revendications 1 à 3, dans lequel l'épaisseur de la deuxième couche (12) est augmentée pour abaisser la tension de seuil $U_{th}$ du transistor (1) et l'épaisseur de la deuxième couche (12) est diminuée pour élever la tension de seuil $U_{th}$ du transistor (1).

5. Procédé selon l'une des revendications 1 à 4, dans lequel la teneur en aluminium $x$ de la deuxième couche (12) est augmentée pour abaisser la tension de seuil $U_{th}$ du transistor (1) ou élever la densité des porteurs de charge $n_s$ et la teneur en aluminium $x$ de la deuxième couche (12) est diminuée pour élever la tension de seuil $U_{th}$ du transistor (1) ou abaisser la densité des porteurs de charge $n_s$.

6. Procédé selon l'une des revendications 1 à 5, dans lequel la sélection du matériau de la quatrième couche est effectuée de telle manière que la tension de seuil $U_{th}$ du transistor (1) se situe entre -4,5 V et -1,0 V.

7. Procédé selon l'une des revendications 1 à 6 dans lequel une mesure de l'effet Hall et/ou une mesure de la photoréflexion sont effectuées.

8. Procédé selon l'une des revendications 1 à 7, dans lequel la tension de seuil $U_{th}$ est modélisée (57) comme suit en fonction du potentiel de surface $\Phi_B$ après application de la quatrième couche (14) et de la densité des porteurs de charge $n_s$ :

$$U_{th} = \frac{\Phi_B}{e} - \frac{\Delta E_c}{e} - \frac{e \cdot n_s \cdot d}{\varepsilon \cdot \varepsilon_0}$$

9. Procédé selon les revendications 1 à 8, dans lequel la tension de seuil $U_{th}$ est déterminée (58) comme suit en fonction de la variation du potentiel de surface $\Delta\Phi_B$ après application de la quatrième couche (14) :

$$U_{th} = U_{th}^0 + \frac{2 \cdot \Delta\Phi_B}{e}$$

Fig. 1

Fig. 9

51 ⌇ ▭

52 ⌇ ▭

53 ⌇ ▭

54 ⌇ ▭

55 ⌇ ▭

56 ⌇ ▭

57 ⌇ ▭    ▭ ⌇ 58

59 ⌇ ▭

Fig. 2

Fig. 3

Fig. 4

Fig. 5

Fig. 6

Fig. 7

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7224004 B2

- US 20070018199 A1

**In der Beschreibung aufgeführte Nicht-Patentliteratur**

- **O. AMBACHER et al.** Pyroelectric properties of Al-GaN/GaN heteroand quantum-well structures. *J. Phys.: Condens. Matter,* 2002, vol. 14, 3399

- **O. AMBACHER et al.** Pyroelectric properties of Al-GaN/GaN hetero- and quantum-well structures. *J. Phys.: Condens. Matter,* 2002, vol. 14, 3399